Europäisches Patentamt

European Patent Office

Office européen des brevets

(19)

(11) Veröffentlichungsnummer: **0 035 225 B1**

(12) **EUROPÄISCHE PATENTSCHRIFT**

(45) Veröffentlichungstag der Patentschrift: 08.05.85

(51) Int. Cl.⁴: **H 03 K 17/945**

(21) Anmeldenummer: 81101341.6

(22) Anmeldetag: 25.02.81

(54) Näherungsschalter mit zugehörigen Überwachungseinrichtungen.

(30) Priorität: 01.03.80 DE 3007929
02.08.80 DE 3029489

(43) Veröffentlichungstag der Anmeldung:
09.09.81 Patentblatt 81/36

(45) Bekanntmachung des Hinweises auf die Patenterteilung:
08.05.85 Patentblatt 85/19

(84) Benannte Vertragsstaaten:
CH FR GB IT LI

(56) Entgegenhaltungen:
DE - A - 2 400 723
FR - A - 2 149 901
US - A - 3 870 948

CONTROL AND INSTRUMENTATION, Band 7, Nr. 8, September 1975, Seiten 52-53 London, G.B. K. CHESTER: "Reliability-inductive proximity switch system fits the bill"

(73) Patentinhaber: Gebhard Balluff Fabrik feinmechanischer Erzeugnisse GmbH & Co., Gartenstrasse 21, D-7303 Neuhausen a.d.F. (DE)

(72) Erfinder: Hermle, Rolf, Dipl.-Kfm., Am Nussberg 1, D-7440 Nürtingen (DE)
Erfinder: Kammerer, Heinz, Ing.grad., Achalmstrasse 29, D-7302 Ostfildern-Nellingen (DE)
Erfinder: Langheinrich, Hans, Dipl.-Ing., Hummelbergweg 38, D-7250 Leonberg (DE)

(74) Vertreter: Hoeger, Stellrecht & Partner, Uhlandstrasse 14c, D-7000 Stuttgart 1 (DE)

**Beschreibung**

Die Erfindung betrifft einen fehlersicheren, berührungslos steuerbaren Näherungsschalter mit einem bedämpfbaren Oszillator mit einem in seiner Impedanz durch Annäherung von zu überwachenden Teilen veränderlichen induktiven oder kapazitiven Steuerelement und mit der Überwachung der Funktionsfähigkeit des Näherungsschalters dienenden Überwachungseinrichtungen mit einem Bedämpfungskreis, mit dessen Hilfe der Oszillator bedämpfbar ist.

Ein derartiger Näherungsschalter ist beispielsweise aus »Control and Instrumentation«, Bd. 7, Nr. 8, September 1975, Seiten 52 und 53, bekannt. Bei dem bekannten Näherungsschalter besteht die Möglichkeit, den Oszillator mittels eines einen Dämpfungswiderstand enthaltenden Dämpfungskreises zu bedämpfen. Hierdurch wird gewährleistet, daß beim Auftreten von Fehlern in der Oszillatorschaltung oder in der zugehörigen Auswerteschaltung kein falscher Betriebszustand angezeigt werden kann. Bei dem bekannten Näherungsschalter erfolgt also eine passive Überwachung in der Weise, daß Änderungen eines Ausgangssignals des Näherungsschalters überwacht werden, um daraus Schlüsse hinsichtlich des Betriebszustandes des Näherungsschalters zu ziehen und beispielsweise zu erkennen, ob der Näherungsschalter bedämpft wird oder nicht oder ob eine Betriebsstörung vorliegt.

Aus der DE-AS 2 140 056 ist ferner ein Näherungsschalter bekannt, der elektrische Überwachungseinrichtungen umfaßt, mit deren Hilfe eine mechanische Beschädigung des Tastkopfs in der Weise ausgewertet werden kann, daß ein normalerweise ständig vorhandenes Prüfsignal auf einer Ausgangsleitung unterbrochen wird.

Der bekannte Näherungsschalter ist insofern besonders vorteilhaft, als bei der Zerstörung bzw. Beschädigung eines Überwachungselementes gewissermaßen ein Voralarm ausgelöst wird, ehe das eigentliche Steuerelement des Näherungsschalters beschädigt werden kann. Andererseits ist bei dem vorbekannten Näherungsschalter eine spezielle Ausgestaltung des Tastkopfes erforderlich, was aus Kostengründen und im Hinblick auf eine möglichst kleine Typenzahl der Tastköpfe unerwünscht sein kann.

Ein Näherungsschalter mit entsprechenden Überwachungseinrichtungen für die elektrischen, insbesondere die elektronischen Bauteile, ist ferner aus der DE-PS 2 166 021 bekannt, gemäß welcher ein Dauersignal erzeugt wird, das anzeigt, daß die miteinander zu vergleichenden Betriebsbedingungen an unterschiedlichen Schaltungspunkten den vorgegebenen Betriebsbedingungen entsprechen, wobei ein Ausfall bzw. eine Unterbrechung dieses Dauersignals dann einen Störfall signalisiert. Bei diesem bekannten Näherungsschalter mit Überwachungseinrichtungen ist ein entsprechender Schaltungsaufwand erforderlich, der ebenfalls in gewissen Fällen zu unerwünscht hohen Kosten führt.

Ausgehend vom Stande der Technik, insbesondere gemäß »Control and Instrumentation«, liegt der Erfindung die Aufgabe zugrunde, einen verbesserten Näherungsschalter anzugeben, bei dem mit geringem Schaltungsaufwand eine gezielte aktive Überwachung in Form einer Funktionsüberprüfung möglich ist, wobei insbesondere überprüft werden soll, ob eine entsprechende Annäherung eines bewegbaren Teils die gewünschte Bedämpfung des Oszillators herbeiführen kann und/oder ob die Ansprechbedingungen des Näherungsschalters noch dem ursprünglich eingestellten Ansprechabstand entsprechen.

Diese Aufgabe wird gemäß der Erfindung dadurch gelöst, daß die Überwachungseinrichtungen und der Bedämpfungskreis derart ausgebildet sind, daß der Bedämpfungskreis zu Prüfzwecken elektrisch schaltbar ist.

Der entscheidende Vorteil der erfindungsgemäßen Ausgestaltung der Überwachungseinrichtungen besteht dabei darin, daß zunächst einmal die Möglichkeit besteht, eine Bedämpfung des Oszillators zu simulieren, die der Bedämpfung durch ein zu überwachendes bewegbares Teil entspricht. Wenn diese zu Prüfzwecken durchgeführte simulierte Bedämpfung dann nicht zu einem entsprechenden Ausgangssignal des Näherungsschalters führt, ist sofort klar, daß eine Funktionsstörung vorliegen muß, die aus Sicherheitsgründen eine Betriebsunterbrechung und entsprechende Reparaturen erforderlich macht. In der Praxis kann eine solche Überprüfung beispielsweise periodisch oder vor jedem Maschinenbefehl ausgeführt werden, der eine Bewegung der zu überwachenden Teile auslöst.

Die erfindungsgemäße Ausgestaltung der Überwachungseinrichtungen ermöglicht aber auch eine Überprüfung des richtigen Ansprechabstandes durch Simulation einer dem Ansprechabstand entsprechenden Bedämpfung des mechanisch unbedämpften Oszillators, der in diesem Fall bei Erzeugung des Prüfsignals nicht weiterschwingen darf, und durch eine definierte Entdämpfung des von außen mechanisch bedämpften Oszillators, der in diesem Fall für die Dauer des Prüfsignals wieder anschwingen muß, da durch die Entdämpfung Betriebsbedingungen eingestellt werden, die einem Ansprechabstand entsprechen, der kleiner ist als die aus Sicherheitsgründen noch zulässige Annäherung der zu überwachenden bewegbaren Teile.

Erfindungsgemäß läßt sich die einwandfreie Funktion des Näherungsschalters also sowohl von außen bedämpftem Oszillator als auch bei von außen nicht bedämpftem Oszillator überprüfen, so daß alle zum Schutz der Maschinen, der Werkstücke und des Bedienungspersonals zu beachtenden Sicherheitskriterien überprüft werden können.

Vorteilhafte Ausgestaltungen des Näherungsschalters gemäß der Erfindung sind Gegenstand von Unteransprüchen.

Der Erfindung liegt ferner die Aufgabe zugrunde, die Überwachungsmöglichkeiten, welche ein einzelner Näherungsschalter gemäß der Erfindung bietet, in optimaler Weise während einer besonders kritischen Betriebsphase, nämlich beim Einschalten einer Maschine optimal zu nutzen, insbesondere beim Anlaufen einer Maschine mit mindestens zwei parallel geschalteten Näherungsschaltern, die den Endpositionen eines beweglichen Maschinenelementes, insbesondere eines längs einer Stange beweglichen Stößels zugeordnet sind, wobei unter »Parallelschaltung« die funktions- und schaltungsmäßige Äquivalenz der Näherungsschalter zu verstehen ist.

Diese Aufgabe wird bei dem Näherungsschalter der vorstehend beschriebenen Art gemäß der Erfindung dadurch gelöst, daß die Überwachungseinrichtungen derart mit den Schalteinrichtungen einer mit dem Näherungsschalter ausgerüsteten Maschinen-Anlaufsteuerung verbunden sind, daß durch jeden Einschaltvorgang zwangsläufig ein elektrisches Schalten des Bedämpfungskreises zum Bedämpfen des Oszillators herbeiführbar ist.

Der entscheidende Vorteil dieser Ausgestaltung der Erfindung besteht dabei darin, daß die Überprüfbarkeit mindestens eines Näherungsschalters auf seine einwandfreie Funktion in die Prüfung der Einschaltfunktionen einer Maschinen-Anlaufsteuerung einbezogen wird; es wird also mit anderen Worten eine Maschinen-Anlaufsteuerung geschaffen, bei der in Verbindung mit dem Einschaltvorgang die Funktionsfähigkeit mindestens eines Näherungsschalters überprüft wird, insbesondere die Funktionsfähigkeit zweier parallel geschalteter Näherungsschalter, wobei gleichzeitig außerdem auch eine Überprüfung der Schaltfunktionen der Einschalteinrichtungen selbst erfolgt, beispielsweise eine Überprüfung von mehreren Relais auf das einwandfreie Öffnen und Schließen ihrer Schaltkontakte.

Weitere Einzelheiten und Vorteile der Erfindung werden nachstehend anhand von Zeichnungen noch näher erläutert und/oder sind Gegenstand von Unteransprüchen. Es zeigt

Fig. 1 ein Schaltbild einer ersten bevorzugten Ausführungsform eines als Öffner einsetzbaren Näherungsschalters gemäß der Erfindung;

Fig. 2 ein Schaltbild einer zweiten bevorzugten Ausführungsform eines als Öffner einsetzbaren Näherungsschalters gemäß der Erfindung;

Fig. 3 ein Schaltbild einer bevorzugten Ausführungsform eines als Schließer einsetzbaren Näherungsschalters gemäß der Erfindung und

Fig. 4a bis 4c ein Schaltbild einer erfindungsgemäßen Maschinen-Anlaufsteuerung mit zwei Näherungsschaltern gemäß Fig. 1.

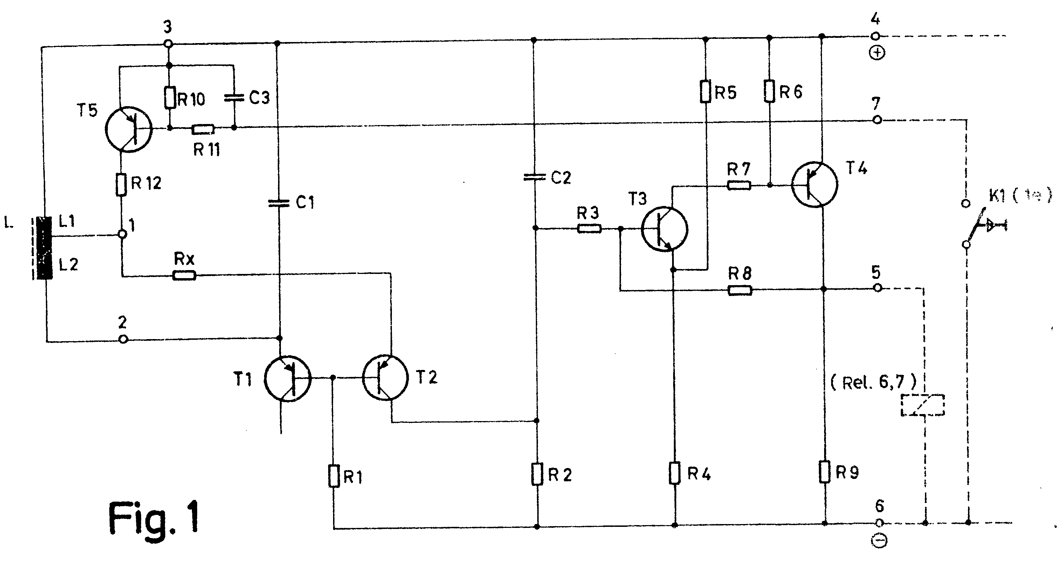

Im einzelnen zeigt das Schaltbild gemäß Fig. 1, wenn man zunächst von den Schaltungselementen zwischen den Schaltungspunkten 1, 3 und 7 absieht, einen üblichen, als Öffner einsetzbaren Näherungsschalter mit einem pnp-Ausgangstransistor. Dieser Näherungsschalter besitzt eingangsseitig eine Tastkopfspule L, die üblicherweise in einem nach vorn — d. h. in Richtung auf die bewegbaren Teile — offenen Topfkern angeordnet ist. Die äußeren Anschlüsse 2, 3 der Tastkopfspule sind mit Anschlüssen 4 und 6 des Näherungsschalters verbunden, an denen eine positive (+) bzw. (über R1, T1) eine negative (−)Spannung anliegt. Parallel zu der Tastkopfspule L liegt ein Kondensator C1, welcher zusammen mit der Tastkopfspule L einen Schwingkreis L, C1 bildet.

Der Oszillator des Näherungsschalters gemäß Fig. 1 weist ferner zwei Transistoren T1 und T2 und drei Widerstände Rx, R1 und R2 auf. Die Basisanschlüsse der Transistoren T1 und T2 sind über den Widerstand R1 mit dem Anschluß 6 des Näherungsschalters verbunden. Der Emitter des Transistors T1 ist einerseits mit dem äußeren Anschluß 2 der Tastkopfspule L und andererseits mit dem Kondensator C1 verbunden. Der Kollektor des Transistors T1 ist nicht beschaltet, so daß lediglich die Basis-Emitter-Strecke des Transistors T1 als Diode wirksam ist, wobei jedoch diese Diode in ihren elektrischen Eigenschaften besonders genau auf die Eigenschaften des Transistors T2 abgestimmt werden kann, dessen Kollektor über den Widerstand R2 mit dem Anschluß 6 verbunden ist und dessen Emitter über den Widerstand Rx mit dem Anschluß 1 des Näherungsschalters verbunden ist, d. h. mit einer Anzapfung der Tastkopfspule L, welche durch diese Anzapfung in zwei Teilwicklungen L1 und L2 unterteilt wird.

Mit dem vorstehend beschriebenen Oszillator ist eine Kippschaltung verbunden, welche einen Kondensator C2, Widerstände R3—R9 und zwei weitere Transistoren T3 und T4 aufweist, wobei der Kondensator C2 auch als Bestandteil des Oszillators anzusehen ist.

Von den genannten Bauelementen ist der Kondensator C2 einerseits an den Anschluß 4 des Näherungsschalters und andererseits an den Kollektor des Transistors T2 angeschlossen. Der gemeinsame Verbindungspunkt des Transistors T2 des Widerstandes R2 und des Kondensators C2 ist über einen Widerstand R3 mit der Basis des Transistors T3 der Kippschaltung verbunden. Der Emitter dieses Transistors T3, der als npn-Transistor ausgebildet ist, ist einerseits über den Widerstand R4 mit dem Anschluß 6 und andererseits über den Widerstand R5 mit dem Anschluß 4 des Näherungsschalters verbunden. Der Kollektor des Transistors T3 ist über den Widerstand R7 mit der Basis des Transistors T4 verbunden. Die Basis des Transistors T4 ist außerdem über den Widerstand R6 mit dem Anschluß 4 verbunden, während der Emitter des Transistors T4 unmittelbar mit der Klemme 4 verbunden ist. Der Kollektor des Transistors T4 ist über den Widerstand R8 mit der Basis des Transistors T3 und über den Widerstand R9 mit dem Anschluß 6 verbunden und bildet einen Anschluß 5, der den eigentlichen Ausgang der Kippschaltung und damit des ganzen Näherungsschalters darstellt. Zwischen den Anschlüssen 5 und 6 können in bekannter Weise Auswerte- und Schalteinrichtungen angeschlossen

3

werden, die in Fig. 1 durch ein gestrichelt eingezeichnetes Relais Rel angedeutet sind.

Bei einem Näherungsschalter der vorstehend beschriebenen Art liegt die Tastkopfspule L normalerweise in einem nach vorn offenen Schalenkern, so daß ein magnetisches Feld mit großer Streuung aufgebaut werden kann. Bewegt man nun in dieses Feld ein Metallteil, so fließen in diesem induzierte Wirbelströme, die dem Feld Energie entziehen. Diese Wirbelstromverluste bewirken eine Verschlechterung der Schwingkreisgüte, so daß sich die Schwingungsamplitude verringert; der Schwingkreis wird also mit anderen Worten bedämpft.

Wenn der Schwingkreis bzw. der Oszillator schwingt, dann bilden die Elemente R2, T2, Rx und L1 für die Dauer der negativen Halbwelle der Schwingung einen Spannungsteiler. Dabei entsteht am Kollektor des Transistors T2 eine verhältnismäßig hohe negative Spannung, weil der Widerstand R2 gegenüber den übrigen Elementen des Spannungsteiles hochohmig ist. Dies hat zur Folge, daß der Kondensator C2 am Eingang der Kippschaltung aufgeladen wird. Wenn der Transistor T2 dann während der positiven Halbwelle der Schwingung sperrt, dann entlädt sich der Kondensator C2 geringfügig über den Widerstand R2, bis die nächste negative Halbwelle der Schwingung auftritt. Der Kondensator C2 glättet also die Spannung am Kollektor des Transistors T2 bzw. am Eingang der Kippschaltung derart, daß sich eine Gleichspannung mit vernachlässigbarer Restwelligkeit ergibt. Diese Spannung ist so hoch, daß die Transistoren T3 und T4 leitend gesteuert sind, so daß das Relais zwischen den Anschlüssen 5 und 6 anzieht.

Wird nun der Schwingkreis, wie oben beschrieben, durch ein Metallteil bedämpft, dann wird die Schwingungsamplitude des Oszillators kleiner, dann wird der Kondensator C2 höher aufgeladen, während die Spannung über dem Widerstand R2 immer geringer wird, bis sie schließlich nicht mehr ausreicht, um den Transistor T3 leitend zu steuern. Mit dem Transistor T3 sperrt dann auch der Transistor T4 und das Relais Rel fällt ab. Bei dem betrachteten Näherungsschalter dient der Widerstand Rx der Einstellung des Ansprechabstandes, d. h. desjenigen Abstandes, bis auf den ein Metallteil an die Vorderseite des Tastkopfes herangeführt werden muß, um die Oszillatorschwingung für ein Kippen der Kippschaltung ausreichend zu bedämpfen.

Wird ein solcher Näherungsschalter zur Überwachung der Betriebsbedingungen an einer Maschine eingesetzt, dann kann eine Funktionsstörung des Näherungsschalters verhängnisvolle Folgen haben. Es ist zwar unkritisch, wenn aufgrund einer Fehlfunktion fälschlicherweise eine Bedämpfung vorgetäuscht wird und das Relais Rel abfällt. In diesem Fall wird nämlich (fälschlich) ein Betriebszustand angezeigt, der verhindert, daß die Maschine eingeschaltet wird. Wenn jedoch tatsächlich eine Bedämpfung des Oszillators vorliegt, beispielsweise weil ein Maschinenteil bald seine Endstellung erreicht hat, das Ausgangssignal des Näherungsschalters jedoch dennoch ein freies Schwingen des Oszillators vortäuscht, was beispielsweise bei einem Durchschlagen eines der Transistoren T2, T3 oder T4 der Fall sein kann, dann kann die Maschine trotzdem anlaufen, wobei es möglicherweie zu einem schweren Sachschaden oder sogar zu einem Personenschaden kommt. Aus diesem Grunde sollte eine Überprüfung der Funktionsfähigkeit des Näherungsschalters möglich sein.

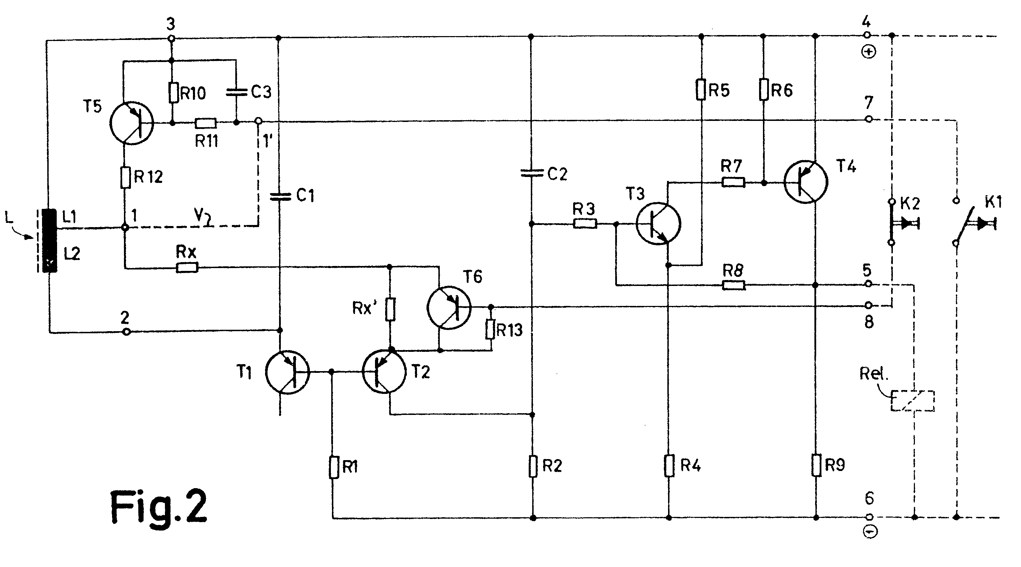

Diese Prüfmöglichkeit kann gemäß der Erfindung bei einem Näherungsschalter gemäß Fig. 1 dadurch geschaffen werden, daß man die Anzapfung der Tastkopfspule L, d. h. den Anschluß 1, über die gestrichelt eingezeichnete Leitung V (Fig. 2) direkt leitend mit dem Anschluß 1' verbindet, der direkt mit einem Anschluß 7 des Näherungsschalters verbunden ist. Wenn man nun am Ende einer mehr oder weniger langen Leitung, die mit den Anschlüssen 4 und 7 des Näherungsschalters verbunden ist, einen Taster K vorsieht, dann kann man durch Schließen des Tasters den Wicklungsteil L1 der Tastkopfspule L kurzschließen. Hierdurch wird die Schwingung des Schwingkreises bzw. des Oszillators gedämpft bzw. unterdrückt, so daß das Relais Rel bei einwandfreier Funktion des Näherungsschalters abfallen, nach Öffnen des Tasterkontaktes jedoch wieder anziehen muß. Dabei kann der Prüfschalter, der in Fig. 1 der Einfachheit halber als Taster K dargestellt ist, ein beliebiger geeigneter Schalter, insbesondere ein elektronischer Schalter sein, der je nach den Besonderheiten der betreffenden Anlage periodisch geschlossen werden kann, um die Funktion des Näherungsschalters zu überprüfen oder auch jeweils vor der Einleitung entsprechender Maschinenfunktionen.

Bei der vorstehend erläuterten, besonders einfachen Variante der Erfindung, bei der kaum ein ins Gewicht fallender zusätzlicher Aufwand erforderlich ist, können sich unter Umständen Schwierigkeiten ergeben, wenn zwischen dem Prüfschalter und den Anschlüssen 4 und 7 des Näherungsschalters ein längeres Kabel vorhanden ist. Die verteilten Induktivitäten und Kapazitäten des Kabels können nämlich einen wirksamen Kurzschluß des Wicklungsteils L1 verhindern. Außerdem wirkt das Kabel wie eine Antenne, über die bei geöffnetem Prüfschalter alle möglichen Störungen im Näherungsschalter wirksam werden können. Hinzu kommt, daß auch die normalerweise ebenso langen Zuleitungen zu den Anschlüssen 5 und 7 eine Leitung mit verteilten Induktivitäten und Kapazitäten bilden, so daß Schaltflanken vom Ausgang der Kippstufe zu einer Rückkopplung auf den Eingang des Näherungsschalters führen, so daß dieser in einem Übergangsbereich in rascher Folge ein- und ausschalten kann. Die vorstehend erläuterte Schaltungsvariante sollte daher nur bei relativ kurzen Anschlußkabeln bis zu einer Länge von etwa 2 m eingesetzt werden. Auch dabei kann es unter Umständen noch erforderlich sein, in den Kurzschlußkreis einen kleinen Serienwiderstand einzufügen.

Wenn eine zumindest weitgehende Unabhängigkeit der Funktionsprüfung von der Länge des Anschlußkabels erreicht werden soll, dann ist es vorteilhaft, wenn statt der Kurzschlußverbindung zwi-

4

# 0 035 225

schen den Anschlüssen 1, 1' und 3 eine Transistorschaltung aus einem Transistor T5, Widerständen R10 und R11 und einem Kondensator C3 vorgesehen ist. Bei dieser Schaltungsvariante liegt die Kollektor-Emitter-Strecke des Transistors T5 zwischen den Anschlüssen 1 und 3. Die Basis des Transistors T5 ist ferner mit dem Anschluß 3 über den Widerstand R10 verbunden und über den Widerstand R11 mit dem Anschluß 1'. Dabei sorgt der Widerstand R10 für die speziell bei höheren Temperaturen wichtige niederohmige Verbindung zwischen Emitter und Basis, während der Widerstand R11 der Begrenzung des Basisstroms dient. Schließlich dient der Kondensator C3 zwischen den Anschlüssen 1' und 3 als Siebglied zum Abblocken von Störspannungsspitzen, die über das Anschlußkabel eintreffen können. Mit Hilfe des Kondensators C3 wird weiterhin die Rückkopplung von Störspannungsimpulsen aufgrund von Ausgangsimpulsen der Kippstufe auf den Eingang des Näherungsschalters unterdrückt.

Bei der betrachteten Schaltungsvariante wird der Transistor T5 beim Schließen des Prüftasters K1 leitend gesteuert, so daß der Wicklungsteil L1 über die Schaltstrecke dieses Transistors kurzgeschlossen werden kann. In Ausgestaltung der Erfindung besteht aber auch die Möglichkeit, in den Kollektorzweig des Transistors T5 einen Widerstand R12 einzufügen, der so bemessen ist, daß die Bedämpfung des Schwingkreises bzw. des Oszillators etwa ebenso groß ist wie die Dämpfung durch ein Metallteil bei dem am Widerstand Rx eingestellten Ansprechabstand. Wenn dann beim Schließen des Prüfschalters K1 das Relais Rel abfällt und beim Öffnen desselben wieder anzieht, dann ist nicht nur sichergestellt, daß der Oszillator des Näherungsschalters überhaupt bedämpft werden kann, sondern auch, daß der Ansprechabstand nicht zu klein geworden ist, was dazu führen könnte, daß der Oszillator des Näherungsschalters weiterschwingt, obwohl sich das zu überwachende Metallteil hinreichend weit genähert hat.

Bei der Schaltung gemäß Fig. 2 der Zeichnung ist der Widerstand für die Einstellung des Ansprechabstandes in zwei Teilwiderstände Rx und R'x unterteilt, die in Serie geschaltet sind, wobei dem Teilwiderstand R'x die Schaltstrecke eines Transistors T6 parallel geschaltet ist. Die Basis des Transistors T6 ist über einen Widerstand R13 mit dem Kollektor desselben und mit dem Verbindungspunkt des Teilwiderstandes R'x und des Emitters des Transistors T2 verbunden. Außerdem ist die Basis des Transistors T6 mit einem Anschluß 8 des Näherungsschalters verbunden, der über einen Prüftaster K2 mit Ruhekontakt mit dem Anschluß 4 des Näherungsschalters verbunden ist. Die Anschlüsse 4 und 8 des Näherungsschalters können dabei mit den Anschlüssen des Prüftasters K2 wieder über ein Kabel entsprechender Länge verbunden sein.

Wenn in der Schaltung gemäß Fig. 2 der Oszillator des Näherungsschalters durch ein zu überwachendes Metallteil, welches sich entsprechend dicht vor dem Tastkopf befindet, bedämpft ist, kann der Transistor T6 durch die Betätigung des Prüftasters K2 leitend gesteuert werden, wodurch der Teilwiderstand R'x überbrückt wird. Hierdurch wird der Widerstandswert des den Ansprechabstand bestimmenden Widerstandes Rx, R'x derart verringert, daß der Oszillator bei einwandfreier Funktion des Näherungsschalters wieder anschwingen müßte. Wenn dies nicht der Fall ist, dann bedeutet dies, daß sich der Ansprechabstand gegenüber dem ursprünglich eingestellten Ansprechabstand verringert hat oder daß das Metallteil näher an den Tastkopf herangeführt wurde als dies bei der Einstellung des Systems vorgesehen war. In beiden Fällen ist also eine Überprüfung des Systems erforderlich, was dadurch angezeigt wird, daß der Oszillator trotz der Tatsache, daß der Teilwiderstand R'x kurzgeschlossen wurde, nicht wieder anschwingt. Im übrigen arbeitet die Schaltung gemäß Fig. 2 so wie dies oben für die Schaltung gemäß Fig. 1 erläutert wurde.

Aus der vorstehenden Erläuterung der Funktion der Schaltung gemäß Fig. 2 wird deutlich, daß auch die Prüfung, ob sich der Oszillator des Näherungsschalters überhaupt bedämpfen läßt, mit den beschriebenen Schaltungskomponenten R'x, T6, R13 und K2 durchgeführt werden kann, wenn man nämlich den Transistor T6 normalerweise im leitenden Zustand hält und ihn dann zu Prüfzwecken sperrt, wobei durch das zusätzliche Wirksamwerden des Teilwiderstandes R'x bei entsprechender Dimensionierung bei einwandfreier Funktion des Näherungsschalters eine Dämpfung der Schwingungen des Oszillators eintreten müßte. Damit ist aber auch klar, daß in Abwandlung der Funktion der Schaltung gemäß Fig. 1 der Widerstand R12 so bemessen werden könnte, daß der Oszillator bei leitendem Transistor T5 schwingen und bei Annäherung eines Metallteils an den Tastkopf bedämpft würde. Wenn dann die bei leitendem Transistor T5 durch den Kurzschlußzweig mit dem Widerstand R12 bewirkte Bedämpfung durch Sperren des Transistors T5 aufgehoben würde, dann könnte der Oszillator bei dem Ausführungsbeispiel gemäß Fig. 2 wieder anschwingen, obwohl sein Schwingkreis durch ein Metallteil von außen bedämpft ist. Die Funktionsfähigkeit des Näherungsschalters ließe sich also auch auf diese Weise überprüfen.

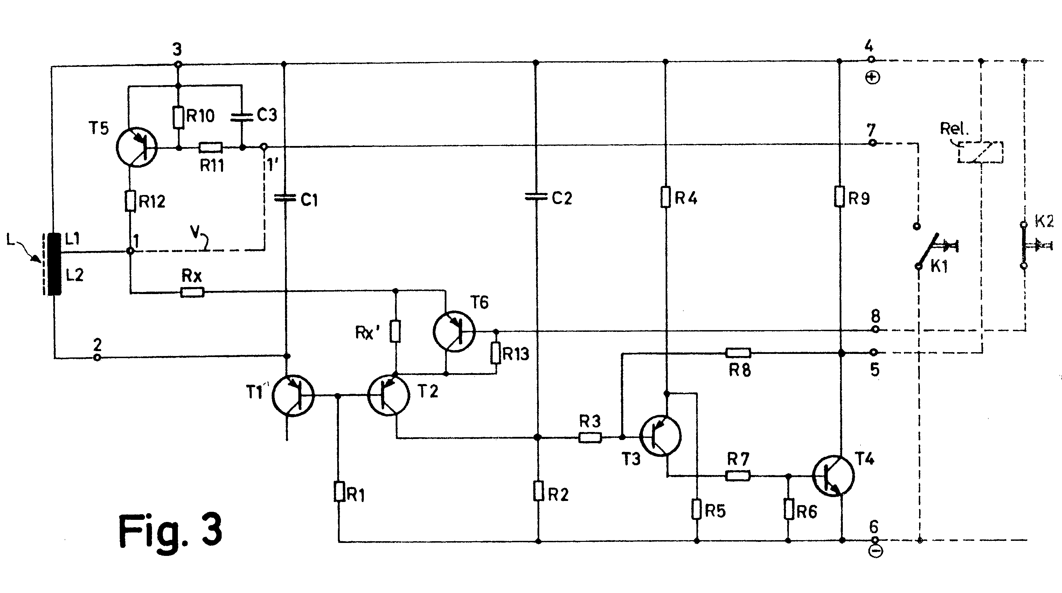

Fig. 3 der Zeichnung zeigt schließlich einen Näherungsschalter gemäß der Erfindung, welcher als Schließer einsetzbar ist und eine Kippschaltung aufweist, deren Ausgangstransistor T4 ein npn-Transistor ist. Die Schaltung gemäß Fig. 3 arbeitet völlig analog zu der Schaltung gemäß Fig. 2, mit dem einzigen Unterschied, daß der Leitfähigkeitstyp der Transistoren T3 und T4 vertauscht ist und daß das Relais Rel an den Anschlüssen 4 und 5 des Näherungsschalters folglich anzieht, wenn der Oszillator ausreichend bedämpft ist und abfällt, wenn der Oszillator frei schwingt.

Bei den Näherungsschaltern gemäß Fig. 1 und 2 lassen sich alle Fehler, die in der Schaltung und im Tastkopf auftreten können, einwandfrei erkennen. Insbesondere werden folgende Fehler sicher erkannt, die auch bei bedämpftem Näherungsschalter eine Schwingung vortäuschen könnten:

5

1. Kondensator C2 ist durchgeschlagen (Kurzschluß);
2. Kollektor-Emitter-Strecke des Transistors T2 ist durchgeschlagen;
3. der Widerstandswert des Widerstandes Rx bzw. der Teilwiderstände Rx, R'x ist unter den Sollwert abgesunken (wenn beispielsweise einer der Widerstände verschmort ist);
4. die Kollektor-Emitter-Strecke des Ausgangstransistors T4 ist durchgeschlagen;
5. die Kollektor-Emitter-Strecke des Eingangstransistors T3 ist durchgeschlagen.

Dabei ist es, wie ein Vergleich der als Öffner dienenden Schaltervarianten mit der als Schließer dienenden Schaltervariante ohne weiteres ergibt, besonders vorteilhaft, daß jeweils gerade die Fehler erkannt werden können, die wirklich zu einer ernsthaften Betriebsstörung bzw. zu einem Unfall führen können. Während nämlich bei den Öffner-Varianten die Kurzschlüsse bereits im Schalter selbst erkannt werden, können bei der Schließer-Variante kalte Lötstellen oder Risse in einem die Bauelemente und Verbindungsleitungen tragenden Träger, insbesondere einen Dickschicht-Substrat erkannt werden, die dort fälschlicherweise zu Schwingungen führen.

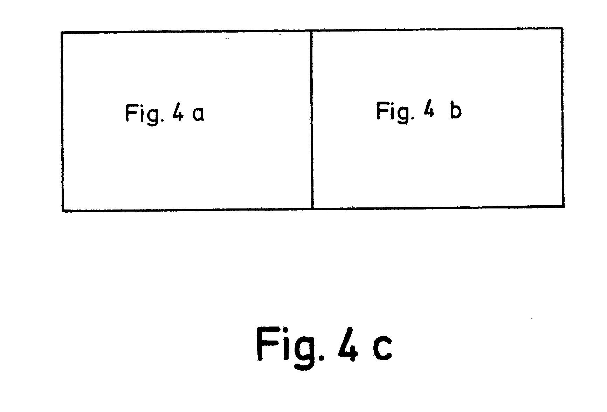

Fig. 4c zeigt eine Maschinen-Einschaltsteuerung für eine Maschine, die mit zwei Näherungsschaltern gemäß Fig. 1 ausgerüstet ist und die nur dann eingeschaltet werden soll, wenn die drei nachfolgenden aufgeführten Bedingungen sämtlich gleichzeitig erfüllt sind:

1. Keiner der beiden Näherungsschalter ist bedämpft; beispielsweise befindet sich also ein längs einer Stange verschiebbarer Stößel, dessen Bewegung bzw. Position überwacht werden soll, zwischen den beiden Schaltern.
2. Beide Näherungsschalter arbeiten, was ihre interne Funktion anbelangt, einwandfrei.
3. Keines der fünf zur Einschaltsteuerung notwendigen Relais, die beim Ausführungsbeispiel als Relais mit zwangsgeführten Kontakten, bzw. als Schütze ausgeführt sind, weist eine Leitungs- bzw. Spulenunterbrechung oder einen Kontakt auf, der in der Einschaltstellung bzw. in der Ausschaltstellung festgeschweißt ist.

Die Prüfung bzw. Überwachung der drei vorstehend aufgeführten Bedingungen erfolgt nun erfindungsgemäß — gemäß einer ersten Variante — während des Niederdrückens einer Einschalt- bzw. Start-Taste »Ein«.

Im einzelnen weist die Maschinen-Einschaltsteuerung gemäß Fig. 4c zunächst einmal die beiden Näherungsschalter »Näherungsschalter 1« und »Näherungsschalter 2« auf (Fig. 4b). Außerdem sind die üblichen Speisespannungsanschlüsse, nämlich der Anschluß 4 ( + ) und der Anschluß 6 ( – ) vorgesehen. Weiterhin sind die schon erwähnte Einschalttaste »Ein« und eine Ausschalttaste »Aus« vorgesehen sowie die fünf bereits oben erwähnten Relais Rel. 1 bis Rel. 5 und zwei weitere, den beiden Näherungsschaltern einzeln zugeordnete Relais Rel. 6 bzw. Rel. 7, die dem Relais Rel in Fig. 1 entsprechen, wo aus diesem Grund bei dem Relais Rel bereits der Hinweis »(Rel. 6, 7)« eingefügt ist. Weiterhin ist der Einschaltsteuerung gemäß Fig. 4c parallel zu den Relais Rel. 1 bis Rel. 5 jeweils eine Freilaufdiode geschaltet und es sind außerdem vier Anzeigelampen LP1 bis LP4 vorgesehen, die zunächst einmal einer einfachen Erläuterung der Funktion der Einschaltsteuerung dienen, aber auch in der Praxis an einem Schaltkasten der Maschine oder dergleichen vorgesehen sein können.

Bei der Einschaltsteuerung gemäß Fig. 4c, in der die einzelnen Relais Rel. 1 bis Rel. 7 in üblicher Weise jeweils mehrere Arbeits- und Ruhekontakte haben, die jeweils zur Bezeichnung des zugehörigen Relais mit der entsprechenden Ziffer bezeichnet sind und außerdem zur Unterscheidung voneinander mit einem klein geschriebenen Buchstaben — der Kontakt 4d ist also beispielsweise ein vierter Kontakt des Relais Rel. 4 — laufen bei einem normalen Startvorgang folgende Vorgänge ab:

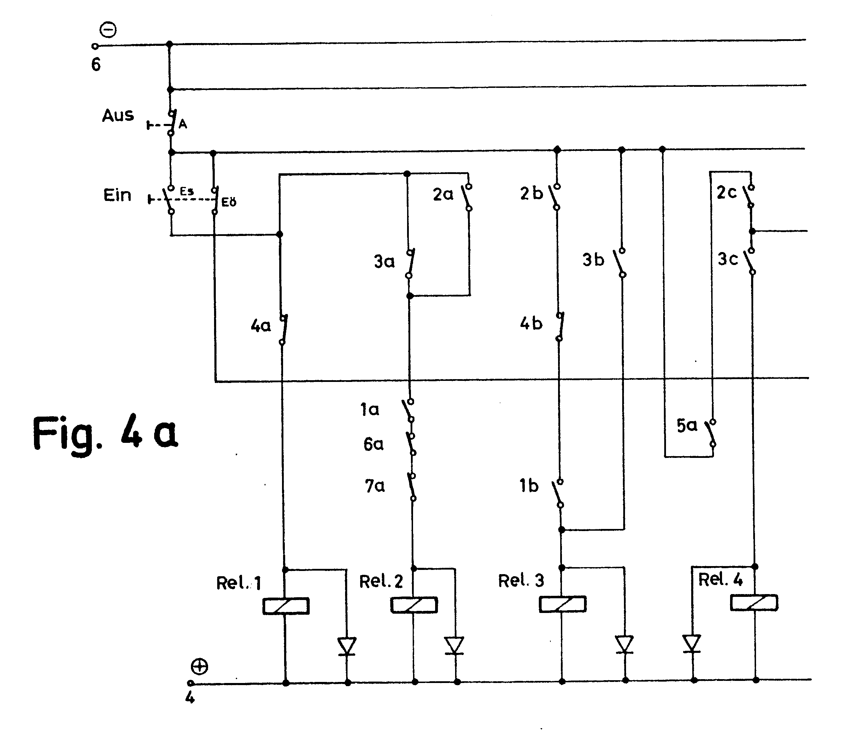

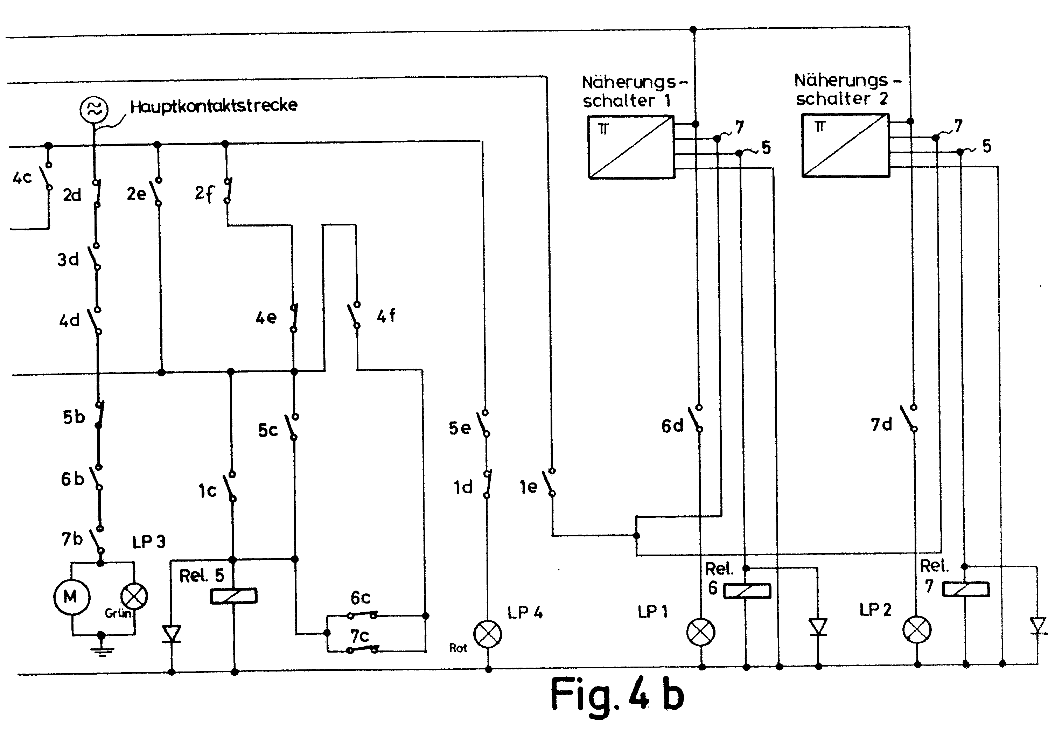

Beim Drücken der Einschalttaste »Ein« fließt ein Strom vom Anschluß 6 über den Ruhekontakt A der Ausschalttaste »Aus« über den Arbeitskontakt Es der Einschalttaste »Ein«, einen Ruhekontakt 4a des Relais Rel. 4 und das Relais Rel. 1 zum Anschluß 4. Das Relais Rel. 1 zieht folglich an, so daß seine Arbeitskontakte 1a, 1b, 1c, 1e schließen, während sein Ruhekontakt 1d öffnet. Das Schließen des Kontaktes 1c bewirkt dabei das Anziehen des Relais Rel. 5 mit den Arbeitskontakten 5a, 5b, 5c und 5e. Der Arbeitskontakt 1e entspricht dabei, wie in Fig. 1 angedeutet, dem Kontakt des Prüftasters K1, so daß eine Scheinbedämpfung der beiden Näherungsschalter erfolgt, deren Anschlüsse 7 parallel zueinander mit dem Konakt 1e verbunden sind. Durch die Bedämpfung der Näherungsschalter fallen deren zugeordnete Relais Rel. 6 und Rel. 7 ab. Hierdurch wird über die Kontakte A, Es, einen Ruhekontakt 3a des dritten Relais Rel. 3, den Arbeitskontakt 1a und die Ruhekontakte 6a und 7a der Relais Rel. 6 und Rel. 7 zwischen den Anschlüssen 4 und 6 ein Stromkreis für das zweite Relais Rel. 2 geschlossen, so daß dieses anzieht. Die Schließer bzw. Arbeitskontakte des zweiten Relais Rel. 2, nämlich die Kontakte 2a, 2b, 2c und 2e schließen folglich, während zwei Ruhekontakte 2d und 2f des zweiten Relais Rel. 2 öffnen. Das Relais Rel. 2 hält sich nunmehr über seinen Arbeitskontakt 2a selbst. Durch das Schließen des Kontaktes 2b (Fig. 4a) wird zwischen den Anschlüssen 4 und 6 über den Kontakt A, den Arbeitskontakt 2b, den Arbeitskontakt 1b und einen Ruhekontakt 4b des vierten Relais Rel. 4 auch ein Stromkreis für das Relais Rel. 3 geschlossen, dessen Ruhekontakt 3a daraufhin öffnet, während seine Arbeitskontakte 3b, 3c, 3d schließen, wobei sich das dritte Relais Rel. 3 anschließend über seinen Arbeitskontakt 3b selbst hält. Damit ist jetzt aber auch zwischen den Anschlüssen 4 und 6 ein Stromkreis für das vierte Relais Rel. 4 über die Arbeitskontakte 2c, 3c, 5a geschlossen, so daß dieses anzieht und sich selbst über seinen Arbeitskontakt 4c hält. Außerdem schließen zwei weitere Arbeitskontakte 4d, 4f, während drei Ruhekontakte 4a, 4b und 4e des vierten Relais Rel. 4 öffnen. Durch das Öffnen des Ruhekontaktes 4a wird dabei der Stromkreis für das erste Relais Rel. 1 unterbrochen, welches daraufhin abfällt. Durch den sich dabei öffnenden Arbeitskontakt 1e wird damit die Scheinbedämpfung für die beiden Näherungsschalter beendet, so daß das sechste und siebte Relais Rel. 6 bzw. Rel. 7 (Fig. 4b) wieder anziehen. Weiterhin wird durch das Öffnen des Arbeitskontaktes 1a der Stromkreis für das zweite Relais Rel. 3 (Fig. 4a) unterbrochen, so daß dieses ebenfalls abfällt. Auch der Arbeitskontakt 1c öffnet beim Abfallen des Relais Rel. 1. Dabei bleibt jedoch über die Leiterstrecke mit den Kontakten 5c und 2e der Stromkreis für das fünfte Relais Rel. 5 noch einen Augenblick geschlossen, bis auch der Kontakt 2e öffnet. Zu diesem Zeitpunkt muß das fünfte Relais abfallen, da der Ruhekontakt 4e geöffnet ist. Sobald das zweite und das fünfte Relais Rel. 2 bzw. Rel. 5 abgefallen sind und die Relais Rel. 6 und Rel. 7 wieder angezogen haben, ist der in Fig. 4b durch besonders starke Linien hervorgehobene Strompfad für die Maschine M geschlossen, so daß nunmehr ein Strom über die Maschine und die Schaltstrecke mit den Kontakten 2d, 3d, 4d, 6b, 7b und 5b fließen kann, wobei eine parallel zur Maschine geschaltete grüne Signallampe LP3 aufleuchtet. Man erkennt, daß die Maschine M gestartet werden kann, wenn die Relais und die Näherungsschalter in Ordnung sind und wenn die Einschalttaste »Ein« zunächst mindestens so lange gedrückt wird, bis die Relais Rel. 1 und Rel. 2 angesprochen haben. Anschließend kann die Einschalttaste »Ein« wieder freigegeben werden, wobei der Einschaltvorgang automatisch bis zum Einschalten der Maschine M weiterläuft.

Damit der ordnungsgemäße Ablauf des Einschaltvorganges mit Prüfung der beiden Näherungsschalter auch der Bedienungsperson deutlich wird, sind den beiden Näherungsschaltern die Anzeigelampen LP1, LP2 zugeordnet, die bei unbedämpften Näherungsschaltern, wenn die Relais Rel. 6 und Rel. 7 angezogen haben, leuchten — ihr Stromkreis wird über die Arbeitskontakte 6d bzw. 7d geschlossen — und die dementsprechend bei der Scheinbedämpfung der Näherungsschalter durch Schließen des Arbeitskonaktes 1e kurzfristig erlöschen müssen. Eine vierte, als rote Lampe ausgebildete Anzeigelampe LP4 dient schließlich dazu, Störungen anzuzeigen.

Während vorstehend einige Grundbedingungen der Maschinen-Einschalt-Steuerung gemäß Fig. 4c erläutert wurden, sind, wie die Zeichnung zeigt, noch weitere Kontakte und Strompfade vorgesehen, die eine besondere Überwachung spezieller Fehlerbedingungen ermöglichen, wie dies für den Fachmann aus dem Schaltbild deutlich wird.

Wie weitgehend die Überwachung bei der Einschaltsteuerung erfindungsgemäß ist, wird aus den nachfolgenden Listen deutlich, von denen die Liste 1 die Fehlermöglichkeiten bei den Bauelementen aufführt, während die Liste 2 Auskunft über verschiedene Störungsfälle an den Relaiskontakten in der Maschinen-Einschaltsteuerung gibt.

Insgesamt wird aus den Listen deutlich, daß praktisch jede Störung, die den Betriebsablauf beeinträchtigen könnte, erfaßt wird, wobei im allgemeinen eine Anzeige über die rote Anzeigelampe LP4 erfolgt, außer in den Fällen, in denen keine Spannung vorhanden ist bzw. keine Spannung durchgeschaltet wird, wobei in diesen Fällen aber auch keine Gefahr für ein Anlaufen bzw. Weiterlaufen der Maschine besteht und folglich ebenfalls keine die Maschine oder das Werkstück gefährdenden Fehler auftreten können. Insbesondere sind in diesem Zusammenhang die Arbeitskontakte 6b und 7b in der Hauptkontaktstrecke zu beachten, welche für eine sofortige Unterbrechung der Speisung der Maschine M sorgen, wenn einer der Näherungsschalter bedämpft wird und das zugehörige Relais abfällt. Die Störung bringt dabei über die Kontakte 6c und/oder 7c auch ein Anziehen des Relais Rel. 5 mit sich, so daß die rote Lampe LP4 aufleuchtet.

(In den folgenden Listen sind die Relais und deren Kontakte nur mit ihren Bezugsziffern bzw. ihren Ziffer-Buchstabenkombinationen angegeben).

Liste 1

| Fall | Bauteil | Defekt | Funktionsbeschreibung | Hauptkontaktstrecke unterbrochen durch | Rote Lampe |
|---|---|---|---|---|---|
| 1 | Rel. 1 | fällt nicht ab | 6 und 7 bleiben abgefallen, 5 bekam über 1c und 2e Spannung, nach Loslassen von E fällt 2 ab, 5 bekommt über 1c (parallel auch 5c) und Eö Spannung | geöffneten 5b, 6b, 7b | nein, da 1d geöffnet |
| 2 | | Abfall verzögert | 5 löst sich nicht mehr, da 1c durch 5c überbrückt wird und 5 dann über 5c und Eö Spannung bekommt | geöffneten 5b | ja, da 5e geschl. und (verzögert) 1d auch schließt |
| 3 | | zieht nicht | Startvorgang beginnt nicht | geöffneten 3d und 4d | nein, da 5e offen |
| 4 | Rel. 2 | fällt nicht ab | 5 bekommt über 1c und 2e Spannung und hält sich über 5c und 2e | geöffneten 2d und 5b | ja, über 5e und 1d |
| 5 | | fällt verzögert (nach Loslassen von E) ab | 5 bekommt über 1c und 2e Spannung und hält sich über 5c und 2e, nach Loslassen von E auch parallel über Eö. Öffnet sich 2e, hält sich 5 über 5c und Eö | geöffneten 5b | ja, über 5e und 1d |
| 6 | | zieht nicht | Startvorgang wird nach Anziehen von 1 gestoppt. 5 bekommt über 2f, 1c (und gleich darauf auch parallel über 5c) Spg. Nach Loslassen von E öffnet sich 1c, aber über 5c und Eö (parallel noch 4 und 2f) hält sich 5 selbst | geöffneten 3d, 4d, 5b | ja, über 5e und 1d |
| 7 | Rel. 3 | fällt nicht ab | Startvorgang wird nach Anziehen von 1 gestoppt, denn 2 kann wegen offenem 3a, 4 wegen offenem 2c nicht anziehen. 5 bekommt über 1c, 4e, 2f Spg., nach Loslassen von E Selbsthaltung über 5c, 4e, 2f (parallel auch über Eö) | geöffneten 4d, 5b | ja, über 5e und 1d |
| 8 | | zieht nicht | Startvorgang wird nach Anziehen von 2 gestoppt, 4 kann wegen offenem 3c nicht anziehen, 5 bekommt über 1c und 2e Spg. nach Loslassen von E kann sich 5 meistens nicht halten, wenn 2e öffnet und Eö nicht sofort schließt | geöffneten 3d, 4d | meist nein, wenn 5 sich nicht selbst hält, d. h. 5e offen |

0 035 225

Liste 1 (Fortsetzung)

| Fall | Bauteil | Defekt | Funktionsbeschreibung | Hauptkontaktstrecke unterbrochen durch | Rote Lampe |
|------|---------|--------|----------------------|----------------------------------------|------------|
| 9 | Rel. 4 | fällt nicht ab | Kein Startvorgang möglich, da 4a offen und 1 keine Spg. bekommen kann. 5 erhält keine Spg. | geöffneten 3d | nein, denn 5e offen |
| 10 | | zieht nicht | Startvorgang wird nach Anziehen von 3 gestoppt. 5 erhält Spg. über 1c und 2e, kann sich nach Loslassen von E aber meist nicht halten, wenn 2e öffnet und Eö nicht sofort schließt | geöffneten 4d | meist nein, wenn 5 sich nicht selbst hält, d. h. 5e offen |
| 11 | Rel. 5 | fällt nicht ab | Startvorgang normal | geöffneten 5b | ja, über 5e und 1d |
| 12 | | zieht nicht | Startvorgang wird nach Anziehen von 3 gestoppt, da 4 wegen geöffnetem 5a keine Spg. bekommt | geöffneten 4d | nein, denn 5 zieht ja nicht an, folglich 5e offen |
| 13 | Rel. 6 (Rel. 7) | fällt nicht ab | Startvorgang wird nach Anziehen von 1 unterbrochen, da 2 wegen offenem 6a (7a) nicht anziehen kann. 5 erhält Spg. über 1c, 4, 2f, nach Loslassen von E über 5c, 4, 2f (auch parallel über Eö). | geöffneten 3d, 4d, 5b | ja, über 5e und 1d |
| 14 | | zieht nicht | Startvorgang normal, 5 fällt wieder ab. Nach Loslassen von E aber bekommt 5 wieder Spg. über Eö, 4f, 6c (7c) | geöffneten 6b (7b) | ja, über 5e und 1d |
| 15 | Näherungs-schalter 1 oder 2 | wird nach erfolg-reichem Start bedämpft oder bekommt Defekt | 5 bekommt Spg. über Eö, 4f, 6c (7c). Anschließend Selbst-haltung über 5c und Eö. Dadurch bleibt 5 angezogen, selbst wenn Näherungsschalter wieder entdämpft wird. | geöffneten 5b, während der Bedämpfung auch durch geöffneten 6b (7b) | ja, über 5e und 1d |
| 16 | | läßt sich nicht (schein-)bedämpfen | wie Fall 13 | wie Fall 13 | wie Fall 13 |
| 17 | | bedämpft oder entspr. defekt | wie Fall 14 | wie Fall 14 | wie Fall 14 |

0 035 225

Fehlerliste für die einzelnen Relaiskontakte

| Fall | Defekt bei Kontakt | Auswirkung (Funktionsbeschreibung) | Hauptkontaktstrecke unterbrochen durch | Rotsignal |
|---|---|---|---|---|
| 18 | 1a | Relais 2 kann nicht anziehen, wie Fall 6 | geöffneten 3d, 4d, 5b | ja, über 5e und 1d |
| 19 | 1b | Relais 3 kann nicht anziehen, wie Fall 8 | geöffneten 3d, 4d | nein, denn 5e offen, da sich 5 nicht selbst hält |
| 20 | 1c | Relais 5 kann nicht anziehen, wie Fall 12 | geöffneten 4d | nein, denn 5 zieht ja nicht an, folglich 5e offen |
| 21 | 1d | Normaler Ablauf, alle sonstigen Fehler werden erkannt | keine Unterbrechung, wenn sonst keine Fehler | bei Fehler: nein, denn Strompfad für Rotsignal unterbrochen |
| 22 | 1e | Keine Scheinbedampfung möglich, wie Fall 13 und 16 | geöffneten 3d, 4d, 5b | ja, über 5e und 1d |
| 23 | 2a | Relais 2 fällt zu früh ab, Zeit reicht nicht, um Relais 4 zum Anziehen und zum Selbsthalten zu bringen | geöffneten 4d | nein, 5 fällt wieder ab, folglich 5e offen |
| 24 | 2b | Relais 3 kann nicht anziehen, wie Fall 8 und Fall 19 | geöffneten 3d, 4d | nein, denn 5e offen, da sich 5 nicht selbst hält |
| 25 | 2c | Relais 4 kann nicht anziehen, wie Fall 10 | geöffneten 4d | ja, über 5e und 1d, denn 5 zieht an über 1c und 2e hält sich über 5c, 4e, 2f |
| 26 | 2d | Normaler Ablauf, aber Hauptkontaktstrecke unterbrochen | Fehler bei 2d | nein, wenn kein weiterer Fehler |
| 27 | 2e | Relais 5 fällt zu früh ab, so daß Relais 4 nicht anzieht | geöffneten 4d | nein, wenn kein weiterer Fehler; ja, wenn bei einem Näh.-Sch. keine Sch.-Bed. möglich |
| 28 | 2f | Normaler Ablauf, wenn kein weiterer Fehler. Wenn keine (Schein-) Bedämpfung möglich, kann Relais 2 jedoch nicht anziehen, 5 ebenfalls nicht | geöffneten 3d, 4d | nein, wenn keine Sch.-Bed. möglich. Ja, wenn mind. 1 Näh.-Sch. ständig (schein) bedämpft |

0 035 225

Liste 2 (Fortsetzung)

Fehlerliste für die einzelnen Relaiskontakte

| Fall | Defekt bei Kontakt | Auswirkung (Funktionsbeschreibung) | Hauptkontaktstrecke unterbrochen durch | Rotsignal |
|---|---|---|---|---|
| 29 | 3a | Relais 2 kann nicht anziehen, wie Fall 6 und 18 | geöffneten 3d, 4d, 5b | ja, über 5e und 1d |
| 30 | 3b | Relais 3 kann sich nicht halten und fällt beim Anziehen von 4 wieder ab. Hierdurch fällt auch 4 wieder ab, 1 zieht wieder an usw., Schaltung klappert während des Drückens von EIN | geöffneten 3d, 4d, 5b | ja, über 5a und 1d |
| 31 | 3c | Relais 4 kann nicht anziehen, wie Fall 10 und 25 | geöffneten 4d | ja, über 5e und 1d (5 zieht an über 1c, 2e, hält sich, wenn 2 abf., über 5c, 4e, 2f) |
| 32 | 3d | Normaler Ablauf, aber Hauptkontaktstrecke unterbrochen | Fehler bei 3d | nein, wenn kein weiterer Fehler |
| 33 | 4a | Kein Start möglich | geöffneten 3d, 4d | nein, 5e bleibt offen |
| 34 | 4b | Relais 3 kann nicht anziehen, wie Fall 8, 19 und 24 | geöffneten 3d, 4d | nein, 5e offen (keine Selbsth. v. Rel. 5) |
| 35 | 4c | Relais 4 kann sich nicht halten, fällt beim Abfallen von Relais 2 ebenfalls ab | geöffneten 4d, 5b | ja, 5e und 1d |
| 36 | 4d | Normaler Ablauf, aber Hauptkontaktstrecke unterbrochen | Fehler bei 4d | nein, wenn kein weiterer Fehler |
| 37 | 4e | Normaler Ablauf, wenn kein weiterer Fehler. Es erscheint dann kein Rotsignal, wenn Relais 3 nicht abgefallen war | — | nein, wenn kein weiterer Fehler |
| 38 | 4f | Normaler Ablauf, wenn kein weiterer Fehler. Es erscheint dann kein Rotsignal, wenn nach dem Einschalten, also während des Maschinenlaufs, einer der Näherungsschalter bedämpft wird oder einen Defekt bekommt. Außerdem kein Einrasten der Abschaltung | geöffneten 6b bzw. 7b, wenn Schalter-bedämpfung oder -defekt zusätzlich) | nein, wenn kein weiterer Fehler; ebenfalls nein, wenn Schalterbe-dämpfung oder -defekt zusätzlich |
| 39 | 5a | Relais 4 kann nicht anziehen, wie Fall 10, 25 und 31 | geöffneten 4d | ja, über 5e und 1d (5 zieht an über 1c, 2e, hält sich, wenn 2 abf., über 5c, 4e, 2f) |

0 035 225

Liste 2 (Fortsetzung)

Fehlerliste für die einzelnen Relaiskontakte

| Fall | Defekt bei Kontakt | Auswirkung (Funktionsbeschreibung) | Hauptkontaktstrecke unterbrochen durch | Rotsignal |
|---|---|---|---|---|
| 40 | 5b | Normaler Ablauf, wenn kein weiterer Fehler, jedoch Hauptkontaktstrecke unterbrochen | Fehler bei 5b | nein, wenn kein weiterer Fehler |
| 41 | 5c | Normaler Ablauf, wenn kein weiterer Fehler. Wenn mindestens ein Näherungsschalter sich nicht bedämpfen läßt und Relais 2 nicht anzieht, fällt Relais 5 nach Loslassen von EIN wieder zurück | — | nein, wenn k. weit. Fehler; auch nein, wenn nicht (schein)bedämpfbar, da Rel. 5 sich nicht selbst hält |
| 42 | 5e | Normaler Ablauf, wenn kein weiterer Fehler. Bei Fehlern kein Rotsignal möglich | — | nein, da Unterbrechung bei 5e |
| 43 | 6a od. 7a | Wie Fall, 6, 18, 29 | geöffneten 3d, 4d, 5b | ja, über 5e und 1d |
| 44 | 6b od. 7b | Wie Fall 26, 32, 36 | Fehler bei 6b od. 7b | nein, wenn kein weiterer Fehler |
| 45 | 6c od. 7c | Normaler Ablauf, wenn kein weiterer Fehler. Kein Rotsignal möglich, wenn nach dem Einschalten (während des Maschinenlaufs) mindestens 1 Näherungsschalter bedämpft wird oder einen Defekt bekommt | (geöffneten 6b bzw. 7b) | nein, denn 5e offen (5 erhält keine Spg.) |

0 035 225

**Patentansprüche**

1. Fehlersicherer, berührungslos steuerbarer Näherungsschalter mit einem bedämpfbaren Oszillator mit einem in seiner Impedanz durch Annäherung von zu überwachenden Teilen veränderlichen induktiven oder kapazitiven Steuerelement und mit der Überwachung der Funktionsfähigkeit des Näherungsschalters dienenden Überwachungseinrichtungen mit einem Bedämpfungskreis, mit dessen Hilfe der Oszillator bedämpfbar ist, dadurch gekennzeichnet, daß die Überwachungseinrichtungen und der Bedämpfungskreis (V, K; T5, R10 bis R12, K1; T6, R13, Rx, K2) derart ausgebildet sind, daß der Bedämpfungskreis zu Prüfzwecken elektrisch schaltbar ist.

2. Näherungsschalter nach Anspruch 1, dadurch gekennzeichnet, daß der Oszillator einen induktiven, eine Tastkopfspule enthaltenden Tastkopf im Schwingkreis enthält und für die Tastkopfspule (L) durch Einschalten des Bedämpfungskreises (V, K; T5, R10—R12, K1) zumindest teilweise ein Kurzschluß herbeiführbar ist.

3. Näherungsschalter nach Anspruch 2, dadurch gekennzeichnet, daß die Tastkopfspule mit einer Anzapfung versehen ist und der Kurzschluß für einen zwischen der Anzapfung und einem der äußeren Anschlüsse liegenden Wicklungsteil (L1) der Tastkopfspule (L) herbeiführbar ist.

4. Näherungsschalter nach Anspruch 2 oder 3, dadurch gekennzeichnet, daß der Kurzschluß unmittelbar mittels eines über entsprechende Zuleitungen angeschlossenen Prüfschalters (K1; K2) herbeiführbar ist.

5. Näherungsschalter nach Anspruch 4, dadurch gekennzeichnet, daß in dem Kurzschlußkreis ein definierter Reihenwiderstand (R12) eingefügt ist.

6. Näherungsschalter nach Anspruch 2 oder 3, dadurch gekennzeichnet, daß der Kurzschluß über die Kollektor-Emitter-Strecke eines Prüftransistors (T5) herbeiführbar ist, die der Tastkopfspule (L) bzw. deren Wicklungsteil (L1) parallel geschaltet ist und die Basisspannung des Prüftransistors über einen Prüfschalter (K1; K2) schaltbar ist.

7. Näherungsschalter nach Anspruch 3 oder 6, dadurch gekennzeichnet, daß der Kollektor des Prüftransistors (T5) mit der Anzapfung der Tastkopfspule (L) verbunden ist, daß der Emitter des Prüftransistors (T5) mit einem mit dem einen Pol (+) einer Speisespannungsquelle verbundenen äußeren Anschluß (3) der Tastkopfspule (L) verbunden ist, daß die Basis des Prüftransistors (T5) über den Prüfschalter (K1) und einen Strombegrenzungswiderstand (R11) mit dem anderen Pol (—) der Speisespannungsquelle verbindbar ist, und daß zwischen Basis und Emitter des Prüftransistors (T5) ein Ableitwiderstand (R10) vorgesehen ist.

8. Näherungsschalter nach Anspruch 7, dadurch gekennzeichnet, daß der Basis des Prüftransistors (T5) ein Siebglied (C3) vorgeschaltet ist.

9. Näherungsschalter nach einem der Ansprüche 6 bis 8, dadurch gekennzeichnet, daß zwischen die Anzapfung der Tastkopfspule (L) und den Kollektor des Prüftransistors (T5) ein definierter Widerstand (R12) eingefügt ist.

10. Näherungsschalter nach einem der Ansprüche 1 bis 9, dadurch gekennzeichnet, daß er einen den Ansprechabstand bestimmenden Widerstand enthält und der Bedämpfungskreis derart ausgebildet ist, daß der wirksame Widerstandswert des den Ansprechabstand bestimmenden Widerstandes (Rx, R'x) durch Einschalten des Bedämpfungskreises (T6, R13, R'x, K2) absenkbar ist.

11. Näherungsschalter nach Anspruch 10, dadurch gekennzeichnet, daß der den Ansprechabstand bestimmende Widerstand in zwei Teilwiderstände (Rx, R'x) unterteilt ist, von denen einer (R'x) durch Betätigung eines Prüfschalters (K2) kurzschließbar ist.

12. Näherungsschalter nach Anspruch 11, dadurch gekennzeichnet, daß dem kurzschließbaren Teilwiderstand (R'x) die Kollektor-Emitter-Strecke eines Schalttransistors (T6) parallel geschaltet ist, dessen Basisspannung durch Betätigung des Prüfschalters (K2) steuerbar ist.

13. Verwendung des Näherungsschalters nach einem der Ansprüche 1—12 in einer Maschinen-Anlaufsteuerung derart, daß die Maschinen-Anlaufsteuerung einen oder mindestens einen weiteren, dazu parallel geschalteten Näherungsschalter enthält und die Überwachungseinrichtungen des Näherungsschalters derart mit den Schalteinrichtungen (Ein, Aus, Rel. 1—Rel. 7) der Maschinen-Anlaufsteuerung verbunden sind, daß durch jeden Einschaltvorgang zwangsläufig ein elektrisches Schalten des Bedämpfungskreises (T5, R10—R12, C3) zum Bedämpfen des Oszillators (L, C1, R1, R2, T1, T2) herbeiführbar ist.

**Claims**

1. A fail-safe proximity switch comprising a dampable oscillator with an iductive or capacitive control element variable in its impedance due to the approach of elements to be monitored and monitoring devices serving to monitor the correct functioning of the proximity switch and having a damping circuit for damping the oscillator, characterized in that the monitoring devices and the damping circuit (V, K; T5, R10 to R12, K1; T6, R13, Rx, K2) are designed such that the damping circuit is electrically switchable for testing purposes.

2. Proximity switch as difined in claim 1, characterized in that the oscillator includes in the oscillatory

13

circuit an inductive feeler head with a feeler coil and the feeler coil (L) is at least partially short-circuited when the damping circuit (V, K; T5, R10 to R12, K1) ist switched in.

3. Proximity switch as defined in claim 2, characterized in that the feeler coil is provided with a tab and that a coil portion (L1) of the feeler coil (L) disposed between the tab and one of the outer connections is short-circuited.

4. Proximity switch as defined in claims 2 or 3, characterized in that the short-circuit is directly caused by a testing switch (K1; K2) connected via corresponding connecting lines.

5. Proximity switch as defined in claim 4, characterized in that a predetermined series resistor (R12) is inserted in the short-circuiting means.

6. Proximity switch as defined in claims 2 or 3, characterized in that the short-circuit is initiated via the collector-emitter circuit of a testing transistor (T5) connected in parallel to the feeler coil (L) or its coil portion (L1) and the base potential of said testing transistor is switchable via a testing switch (K1; K2).

7. Proximity switch as defined in claims 3 or 6, characterized in that the collector of the testing transistor (T5) connects to the tab of the feeler coil (L), that the emitter of the testing transistor (T5) connects to an outer connection (3) of the feeler coil (L), said outer connection being connected to one terminal (+) of a power source, that the base of the testing transistor (T5) is connectable to the other terminal (−) of the power source via the testing switch (K1) and a current limiting resistor (R11), and that a shunt (R10) is provided between base and emitter of the testing transistor (T5).

8. Proximity switch as defined in claim 7, characterized in that a filtering element (C3) is provided at the input to the base of the testing transistor (T5).

9. Proximity switch as defined in any of claims 6 to 8, characterized in that a predetermined resistor (R12) is inserted between the tab of the feeler coil (L) and the collector of the testing transistor (T5).

10. Proximity switch as defined in any of claims 1 to 9, characterized in that it includes a resistor determining the activation distance and the damping circuit is designed such that the effective resistivity of the resistor (Rx, R′x) determining the activation distance is reducible when the damping circuit (T6, R13, R′x, K2) is switched in.

11. Proximity switch as defined in claim 10, characterized in that the resistor determining the activation distance is divided into two resistors (Rx, R′x), one of which (R′x) is capable of being short-circuited by actuation of a testing switch (K2).

12. Proximity switch as defined in claim 11, characterized in that the collector-emitter circuit of a switching transistor (T6) is connected in parallel to the resistor (R′x) which is capable of being short-circuited, the base potential of said switching transistor being controllable by actuation of the testing switch (K2).

13. Use of the proximity switch as defined in any of claims 1 to 12 in a machine starting control circuit such that the starting control circuit includes one or at least one additional proximity switch connected in parallel thereto and the monitoring devices of the proximity switch are connected to the switching means (On, Off, Relay 1 to Relay 7) of the starting control circuit such that each starting procedure necessarily initiates an electrical switching of the damping circuit (T5, R10 to R12, C3) for damping the oscillator (L, C1, R1, R2, T1, T2).

## Revendications

1. Détecteur de proximité protégé contre les défauts, commandé sans contact mécanique et comprenant un oscillateur à amortissement, un élément de commande inductif ou capacitif d'impédance variable par approche des pièces à surveiller, et des dispositifs de surveillance de l'aptitude fonctionnelle du détecteur de proximité, avec un circuit d'amortissement de l'oscillateur, ledit détecteur étant caractérisé en ce que les dispositifs de surveillance et le circuit d'amortissement (V, K; T5, R10 à R12, K1; T6, R13, Rx, K2) sont réalisés de façon à permettre la commutation électrique du circuit d'amortissement à des fins de test.

2. Détecteur de proximité selon revendication 1, caractérisé en ce que l'oscillateur comprend dans le circuit oscillant une sonde inductive, comportant une bobine; et un court-circuit au moins partiel de la bobine (L) de sonde est réalisable par branchement du circuit d'amortissement (V, K; T5, R10−R12, K1).

3. Détecteur de proximité selon revendication 2, caractérisé en ce que la bobine de sonde comporte une prise; et une partie (L1) de l'enroulement de la bobine (L) de sonde, comprise entre la prise et une borne extérieure, peut être court-circuitée.

4. Détecteur de proximité selon une des revendications 2 ou 3, caractérisé en ce que le court-circuit est réalisable directement à l'aide d'un interrupteur de test (K1; K2) relié par des fils de connexion appropriés.

5. Détecteur de proximité selon revendication 4, caractérisé par l'insertion d'une résistance série (R12) définie dans le circuit de court-circuitage.

6. Détecteur de proximité selon une des revendications 2 ou 3, caractérisé en ce que le court-circuit est réalisable par le circuit collecteur-émetteur d'un transistor de test (T5), branché en parallèle avec la bobine (L) de sonde ou la partie (L1) de son enroulement; et la tension de base du transistor de test est commutable par un interrupteur de test (K1; K2).

7. Détecteur de proximité selon une des revendications 3 ou 6, caractérisé en ce que le collecteur du transistor de test (T5) est relié à la prise de la bobine (L) de sonde; l'émetteur du transistor de test (T5) est relié à une borne (3) extérieure de la bobine (L) de sonde, connectée à une borne (+) d'une source de tension d'alimentation; la base du transistor de test (T5) peut être reliée à la seconde borne (−) de la source de tension d'alimentation par l'interrupteur de test (K1) et une résistance limitatrice du courant (R11): et une résistance de fuite (R10) est prévue entre la base et l'émetteur du transistor de test (T5).

8. Détecteur de proximité selon revendication 7, caractérisé par un élément de filtrage (C3) branché en amont de la base du transistor de test (T5).

9. Détecteur de proximité selon une quelconque des revendications 6 à 8, caractérisé par l'insertion d'une résistance (R12) définie entre la prise de la bobine (L) de sonde et le collecteur du transistor de test (T5).

10. Détecteur de proximité selon une quelconque des revendications 1 à 9, caractérisé en ce qu'il comprend une résistance déterminant la distance de réponse; et le circuit d'amortissement est réalisé de façon que le branchement du circuit d'amortissement (T6, R13, R'x, K2) permette de réduire la valeur effective de la résistance (Rx, R'x) déterminant la distance de réponse.

11. Détecteur de proximité selon revendication 10, caractérisé en ce que la résistance déterminant la distance de réponse est divisée en deux résistances partielles (Rx, R'x), sont une (R'x) peut être court-circuitée par manoeuvre d'un interrupteur de test (K2).

12. Détecteur de proximité selon revendication 11, caractérisé par le branchement en parallèle avec la résistance partielle (R'x) court-circuitable du circuit collecteur-émetteur d'un transistor de commutation (T6), dont la tension de base est commandée par manoeuvre de l'interruption de test (K2).

13. Utilisation du détecteur de proximité selon une quelconque des revendications 1 à 12 pour une commande de démarrage de machine, de façon que ladite commande comporte un ou au moins un autre détecteur de proximité en parallèle et que les dispositifs de surveillance du détecteur de proximité soient reliès aux dispositifs de commutation (en, hors, Rel. 1—Rel. 7) de la commande de démarrage de machine, de façon que chaque mise sous tension produise obligatoirement une commutation électrique du circuit d'amortissement (T5, R10—R12, C3) pour l'amortissement de l'oscillateur (L, C1, R1, R2, T1, T2).

0 035 225

Fig. 1

Fig.2

Fig. 3

Fig. 4 a

Fig. 4 b

| Fig. 4 a | Fig. 4 b |

# Fig. 4 c